# EUROPEAN PATENT SPECIFICATION

(11) **EP 0 946 407 B1**
(45) Date of publication and mention of the grant of the patent: **25.09.2002**
(21) Application number: 97949005.9
(22) Date of filing: 16.12.1997
(51) Int. Cl.: C01B 7/24, C01B 7/20

(54) **DEVICE AND METHOD FOR THE STORAGE, TRANSPORTATION AND PRODUCTION OF ACTIVE FLUORINE**
VORRICHTUNG UND VERFAHREN ZUM SPEICHERN, TRANSPORTIEREN UND HERSTELLEN VON AKTIVEM FLUOR
PROCEDE AMELIORE DE CONSERVATION, DE TRANSPORT ET DE PRODUCTION DE FLUOR ACTIF

(30) Priority: 19.12.1996 GB 9626329
(43) Date of publication of application: 06.10.1999
(73) Proprietor: British Nuclear Fuels PLC, Preston, Lancashire PR4 0XJ (GB)
(72) Inventor: WAKEFIELD, Leigh Edward, British Nuclear Fuels plc, Preston, Lancashire PR4 0XJ (GB); WHYTE, Barnaby John, British Nuclear Fuels plc, Preston, Lancashire PR4 0XJ (GB)
(74) Representative: Stuttard, Garry Philip
(86) International application number: GB9703347
(87) International publication number: WO98027005

(56) References cited:
- US-A- 3 143 391
- US-A- 3 361 543
- US-A- 3 989 808
- US-A- 4 284 617
- CHEMICAL ABSTRACTS, vol. 85, no. 12, 20 September 1976 Columbus, Ohio, US; abstract no. 80474, FOGLE, C. E. ET AL: "Solid reactants for fluorine gas generators" XP002062746 & U. S. NTIS, AD REP. (1976), AD-A022099, 112 PP. AVAIL.: NTIS FROM: GOV. REP. ANNOUNCE. INDEX (U. S.) 1976, 76(10), 211 CODEN: XADRCH, 1976,

## Description

This invention relates to the transportation, storage and production of active fluorine from safer sources and forms and in particular, but not exclusively to chlorine based active fluorine.

Active fluorine sources have many uses in industry. These include its use as a specialised fluorinating agent and rocket fuel as well as a high performance cleaning agent due to its extremely reactive nature. They can also be used to enhance the anti-corrosion properties of metals.

In semi-conductor manufacture they are used for etching silicon and as a cleaning agent. Semi-conductor and liquid crystal manufacture give rise to silicon and silicon oxide which adheres or deposits on the manufactured units. This material is effectively removed by active fluorine.

However, conventionally used sources of active fluorine in their form ready for use are highly dangerous substances and consequently there are exceedingly strict transportation regulations. The dangers with active fluorine sources arise from the fact that at room temperature and pressure they tend to be extremely reactive. Organic substances for example will react immediately with many active fluorine sources and ignite. Many active fluorine sources also react violently with water giving an emission of toxic fumes. Additionally many active fluorine sources react with any moisture in air and on contact with body tissue produce substances which are both toxic and corrosive to the body. Active fluorine sources are not only a toxic hazard but can also be a fire hazard.

Presently active fluorine sources are stored and transported in relatively small pressurised cylinders.

The present invention seeks to overcome the above-mentioned problems by providing a system and method for the provision of an active fluorine gas source at the point of use which is convenient and safer to store and transport.

In accordance with one aspect of the present invention there is provided a system for producing active fluorine comprising :-
i) a transportable vessel containing a solid alkali metal fluorohalate, preferably tetrafluorohalate,
ii) means for heating the solid alkali metal fluorohalate, and
iii) an outlet from the vessel from which the active fluorine gas produced on heating exits the vessel.

The alkali metal fluorohalate may be MXF₍ₙ₊₁₎, where M is K, Rb or Cs, X is Cl, Br, I and n is 1, 3, 5 or 7. A mixture of alkali metal fluorohalates may be provided.

The active fluorine may be or may include F, F₂, ClF, ClF₃, ClF₅, IF₅, IF₇, BrF, BrF₃, BrF₅ or mixtures thereof. The gas produced may include Cl₂, Cl, Br₂, Br, I, I₂ or mixtures thereof.

Active fluorine consists of highly energetic fluorine species, such as a fluorine radical.

The fluorohalate, and preferably tetrafluorohalate, may be bromate or iodate but is preferably chlorate.

Any alkali metal may be employed. Preferably the solid alkali metal tetrafluorochlorate is KClF₄, or alternatively it may be RbClF₄, or CsClF₄, or any other suitable alkali metal which may provide a solid suitable for transportation.

The alkali metal fluorohalate, such as tetrafluorohalate is preferably provided in pellet form within the transportable vessel. The pellets may be provided on support layers.

The transportable vessel is preferably a cylinder which is adapted to be able to contain the solid alkali metal fluorohalate. A nickel or monel lined cylinder may be used. A filter may be provided, most preferably at the outlet, to help retain the solids. A sintered filter may be preferred.

The alkali metal fluorohalate may be charged to a cartridge capable of insertion into the transportable vessel.

The heater is preferably an integral part of the vessel so that the gas may be produced easily at any point of use. The heater may be provided in the form of heat transfer fins made for example of suitable metal strips. These fins may be provided in the vessel and may extend radially outwards from the centre of the vessel providing an effective heat source to the core of the vessel. Alternatively the heater may be provided separately and applied at the point of use, as required when the production of the active fluorine gas is needed.

An outlet for the vessel may preferably be an industry standard fitting or flange.

The system may be provided with a control system to regulate the temperature and/or pressure generated by heating.

The system may be recharged following use. The device may be recharged using material extracted from the waste stream following the use of the active fluorine, for instance from a scrubber such as a KF scrubber system which selectively absorbs the active fluorine in a re-releasable form.

According to a second aspect of the present invention there is provided a method of providing a source of active fluorine comprising:-
i) generating a solid alkali metal fluorohalates, preferably tetrafluorohalate,
ii) transporting and storing the source as a solid alkali metal fluorohalate, and
iii) heating the fluorohalate at the point of use to generate active fluorine gas.

The active fluorine may comprise fluorine alone or in combination with any halogen but fluorine.

The active fluorine may be or may include F, F₂, ClF, ClF₃, ClF₅, IF₅, IF₇, BrF, BrF₃ or mixtures thereof. The gas produced may include Cl₂, Cl, Br₂, Br, I, I₂ or mixtures thereof.

Active fluorine consists of highly energetic fluorine species, such as a fluorine radical.

The fluorohalate, and preferably tetrafluorohalate, may be iodate or bromate, but is preferably the chlorate form.

Any alkali metal may be employed. The solid alkali metal tetrafluorochlorate to be produced is preferably KClF₄, but it may alternatively be RbClF₄, or CsClF₄, or any other suitable alkali metal tetrafluorochlorate.

In order to produce active fluorine from the MClF₄, (where M equals alkali metal) contained within the vessel, the solid is heated to a temperature at which the MClF₄, decomposes to form active fluorine gas.

The solid alkali metal tetrafluorochlorate is preferably heated to a temperature of at least 90°C or 100°C to cause the generation of active fluorine. Alternatively temperatures of at least 130°C, or at least 180°C may be used. Preferably a temperature of 90°C to 300°C or 325°C is used to decompose the alkali metal tetrafluorochlorate to form active fluorine gas, on demand.

Preferably the decomposition is carried out in a vacuum or in an inert gas stream or merely in the presence of active fluorine.

According to a third aspect of the invention we claim the use of alkali metal fluorohalate, preferably tetrafluorohalate, as a transportable and/or storable source of active fluorine.

The use of alkali metal tetrafluorochlorate as a source of active fluorine is preferred. This technique offers significant safety advantages as the inventory of free active fluorine is kept to a minimum.

According to a fourth aspect of the invention we provide the use of active fluorine as a cleaning agent and/or etching agent.

Preferably the active fluorine is produced using the system of the first aspect and/or the method of the second aspect.

Preferably the active fluorine is used for cleaning chemical vapour deposition equipment. The active fluorine may be used for removal of silicon and/or germanium and/or copper and/or compounds thereof, from semi-conductor manufacturing apparatus, liquid crystal manufacturing apparatus or associated accessories thereof.

The removal of silicon is particularly preferred. The active fluorine may be used for etching silicon, germanium, copper or compounds thereof.

The active fluorine may be used to clean other apparatus or equipment or locations, such as piping.

According to a fifth aspect of the invention we provide a method of cleaning and / or etching comprising producing active fluorine by the system of the first aspect of the invention and / or according to the method of the second aspect of the invention and applying the active fluorine to a material to be cleaned or etched.

According to a sixth aspect of the invention we provide a method of passivating metals by fluorination using active fluorine generated using the system of the first aspect of the invention and/or using the method of the second aspect of the invention.

The invention will now be described in detail, by way of example only, and with reference to the following figures in which :-
Figure 1 is an illustration of a storage unit according to the invention; and
Figure 2 is a schematic diagram illustrating the provision of the active fluorine in accordance with the present invention.

Solid KClF₄, within the vessel may be transported and stored wherever the active fluorine is required with free active fluorine only being generated when there is a demand for such gas. The provision of the active fluorine in this way offers a number of benefits over the prior art metallic cylinders containing active fluorine or sources thereof. Firstly the KClF₄, is a comparatively stable substance, when compared with other active fluorine sources, giving a higher level of safety during transport and storage. Its ease of loading into the transport means is also increased as cartridges incorporating the material, a solid, can be more readily provided. Its effectiveness as a source of cleaning gas is also higher than prior art sources such as fluorine ions. Equally the materials can be employed at room temperatures as a plasma is no longer needed. Significantly the active fluorine source is also free of carbon materials avoiding CFC formation and release.

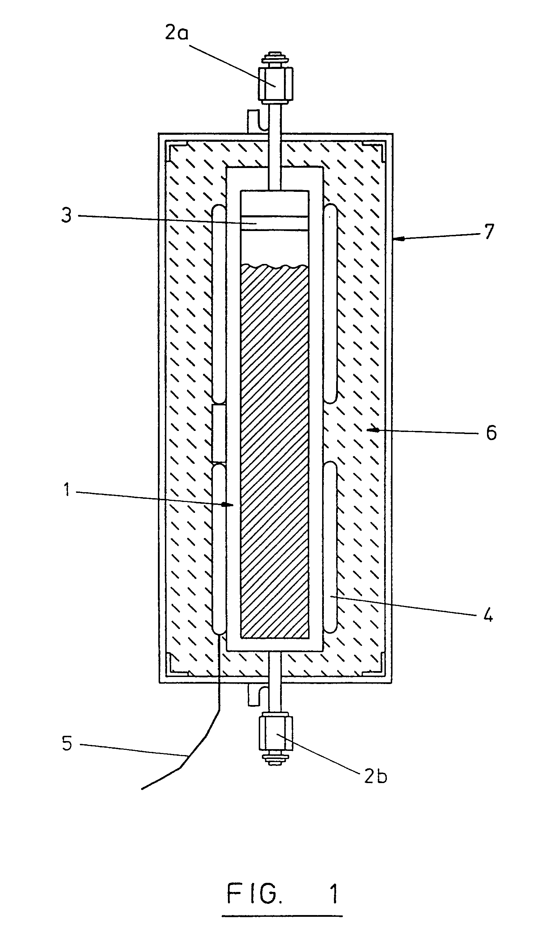

Figure 1 illustrates a cylinder according to an embodiment of the invention in which the cylinder 1 is provided at each end with a valve 2a, 2b. The solid KClF₄ is stored within the cylinder 1 and a sintered filter 3 is provided between the solid and outlet valve 2a. Heating elements 4 are wrapped around or placed against the cylinder 1 and provided with power via leads

A thermocouple is provided to monitor the heating. Encasing the assembly is a layer of thermal insulation 6 which itself is contained within a structural safety jacket 7.

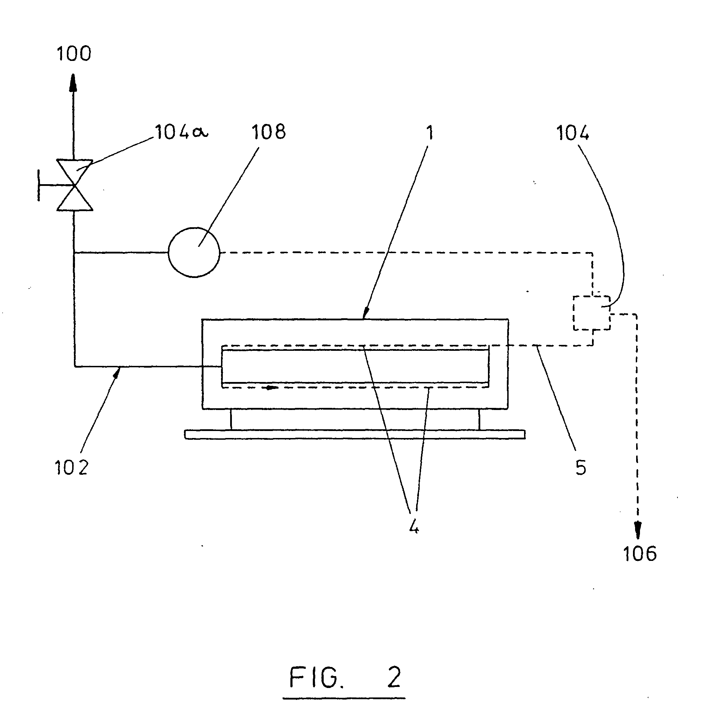

The present invention is exemplified by the generation of active fluorine from a device as illustrated in Figure 2.

In order to obtain the active fluorine gas at the point of use, Figure 2, the cylinder 1 is connected to the location of use 100 via a pipe 102 incorporating a control valve 104a. Electrical connections are attached to the leads 5 and a power supply 106 attached.

Under the control of a heater switch 104 power is introduced to the heating elements 4. The KClF₄ as a consequence is heated to a temperature of up to 300°C, and preferably 230°C, by the integral heating elements 4. The heating is monitored by the use of a thermocouple. At this temperature the solid releases some gas and the gas is released into the pipe. The filter in the cylinder restrains any solid. The pipe 102 directs the gas to the location 100 required.

The heater switch 104 can be controlled by a signal from a pressure monitor 108 connected to the gas outlet pipe 102 to maintain steady production.

Different decomposition temperatures are employed for other alkali metal tetrafluorochlorates; higher temperatures being employed for Caesium for instance.

### Embodiment 1

When the cartridge charged with the granular agent (equivalent of 100g of KClF₄) carrying KClF₄ on the Ni carrier using the unit of this invention as shown in Figure 1 is gradually heated by the heater elements 4 from outside with its outlet valve 2a closed, the rise of pressure inside the cartridge was observed, and a level of 1 kgf/cm² was observed at 220°C. When the outlet valve 2a was opened to allow flowrate of 2ml/min whilst keeping the temperature at 240°C, generation of gas was confirmed by a float system flow meter. The generation of gas was continued in that state. However, when the heater was switched off, a drop in the flow rate was observed as the temperature decreased.

For information, the cartridge to be charged with the agent should preferably be made of heat resistant and anti-corrosive materials such as Monel and Ni, but stainless steel such as SUS 316L can also be used.

### Embodiment 2

Gas was generated for a while by the use of the same unit as that in Embodiment 1 with the temperature kept at 240°C. Thereafter the heater was switched off and disconnected, and the air feed cartridge was cooled down from the outside. As a result, the outlet pressure became the atmospheric pressure at 220°C, and generation of gas stopped.

When the cartridge was heated again, gas was generated at 240°C, and the generation pressure increased as the temperature rose.

When the composition on the internal surface of the cartridge was analyzed after sufficiently replacing the gas inside the cartridge with N₂, after the end of gas generation and returning temperature to the room temperature, the material found there was only fluorine, except the constituents of stainless steel SUS 316L which was the cartridge material. Chloride could hardly be detected.

### Embodiment 3

When the cartridge, charged this time with 50g of granular KClF₄, was gradually heated with the heater from outside, while a high purity N₂ was flowing at the rate of 20 ml/minute from its bottom side 2b using the same unit as that in Embodiment 1, generation of active fluorine was observed at 120°C.

When the temperature was raised up to 180°C, a rise in concentration of relative active fluorine could be observed as the temperature rose. The relative concentration of active fluorine was measured by detecting hydrogen fluoride using a detection tube.

Examples of the use of active fluorine produced in this way and its benefits compared with prior art sources are now exemplified, firstly with reference to the fluorination of steel and subsequently with reference to iron, nickel, aluminium, magnesium and finally chromium.

### Embodiment 4

EP 1/2 inch piping made of austenite stainless steel SUS 316L, was treated with diluted fluoric acid to removing the natural oxidized film, washed with water and dried for use as a test piece.

After moisture was removed by baking at 150°C, again while flowing a high purity N₂ stream first, the gas supplied from the active fluorine generating unit was flowed at room temperature to performing fluorination treatment. For stabilizing the film formed on the internal face of SUS 316L at this time, heat treatment was made at 350°C while flowing a high purity N₂ for forming a stable passive state film. The film compound was found by XDF thin film formation method to be mainly FeF₂, and it was confirmed that the metallic compound (percentage) of SUS 316L remained almost unchanged.

In addition, observation of the surface after sealing with water containing 100 wtppm hydrogen bromide applied to the EP 1/2 inch column, made similarly of SUS 316L, at 50°C for 1 week gave no change on visual inspection, nor when observed by the XDF thin film method.

### Comparison example 1

### Fluorination of stainless steel SUS 316L.

EP 1/2 inch pipe made of austenitic stainless steel SUS 316L, was treated with the hydrofluoric acid to remove the natural oxidized film, washed with water and dried for use as a test piece.

After removing the moisture by baking the test piece at 250°C while flowing a high purity N₂ stream first, the high purity hydrofluoric acid was flowed at 220°C to perform the fluorination treatment. At this time, to stabilize the film formed on the internal face of the SUS 316L piping, heat treatment at 350°C while flowing a high purity N₂ stream was applied. The film composition was mainly the FeF₂, which was measured by XDF thin film method, and it was confirmed that the metal composition (percentage) of SUS 316L remained almost unchanged.

Further, when the surface of an EP 1/2 inch column made of SU3 316L that was prepared similarly was observed after sealing with water containing 100 wtppm hydrogen bromide, at 50°C for one week there was no visible change nor any change of composition observed even with the XDF thin film method.

However, when the fluorination treatment was conducted at the same room temperature as that of Embodiment 1, a perfect FeF₂ film was not formed, and fluorination was found to be insufficient.

### Embodiment 5

### Fluorination of iron, nickel, aluminium and magnesium

Tubes of iron, nickel, aluminium and magnesium of purity of 99.9% or higher, were respectively treated with diluted hydrofluoric acid (then nitric acid + ammonium fluoride for the aluminium) to remove the natural oxidized film, washed with water and dried for use as the test pieces.

After removing the water content by baking at 150°C, again while flowing a high purity N₂ stream first, the gas supplied from the active fluorine generating unit was flowed at room temperature to perform the fluorination treatment. In order to stabilize the film formed on the internal face of each metallic tube at this time, a stable passive film was formed by heat treatment at 350°C, while flowing a high purity N₂ stream. The film compositions were confirmed to be mainly FeF₂, NiF₂, AIF₃ and MgF₂ by XDF thin film method.

### Embodiment 6

### Fluorination of chrome.

A chrome tube of purity of 99.97 or higher, was treated with diluted hydrofluoric acid to remove the natural oxidised film, washed with water and dried for use as the test piece.

After removing the moisture content by baking at 150°C after again initially flowing a high purity N₂ stream, the gas supplied together with the high purity N₂ from the active hydrofluoric acid generating unit like that in Embodiment 3 was flowed at room temperature to perform the fluorination treatment. At this time, for stabilizing the film formed on the internal face of the chrome tube, a stable passive film was formed by heat treatment at 200°C while flowing a high purity N₂ stream.

The film composition was confirmed to be mainly CrF₃ by the XDF thin film method.

Because chrome produces volatile CrF₅ and splashes under fluorination conditions of metal in Embodiment 5, a stable passive film can not be formed.

The use of active fluorine produced by the present invention is now illustrated in terms of the etching and cleaning of silicon, silicon oxide, silicon nitride and silicon carbide. Again comparison with fluorine produced from prior art sources is provided.

### Embodiments 7 and 8

### Etching and cleaning of silicon.

One face of an n-type silicon wafer, which was masked with the PMMA-based resin, and cut out to the size of 5 x 5 mm and whose surface, fat/grease/oil, oxidation and stains were removed, was used as a test piece.

The test piece just after its preparation was installed inside the plasma CVD unit, and was made to react by introducing the undiluted active fluorine at a pressure of 5 Torr at a the flow rate of 30 SCCM at room temperature with the high frequency power source switched off.

Table 1 shows the result of investigating the reduction in mass of silicon for a gas passing time of 60 and 100 minutes. The F in the gas name column indicates the active fluorine generated by this invention.

### Comparison Examples 2 to 6:

### Etching and cleaning of silicon

Table 1 shows the result of reacting the fluorine, nitrogen trifluoride, carbon tetrafluoride, dicarbonhexafluoride, a mixed gas of 95% carbon tetrafluoride and 5% oxygen, and a mixed gas of 5% dicarbonhexfluoride and 5% oxygen for the gas passing time of 100 minutes under the same conditions and using the same test pieces as those of Embodiments 7 and 8.

**Table 1**

| | Circuit Board | Gas Name | Gas passing time | Reduction mass | Remarks |
|---|---|---|---|---|---|
| Embodiment 7 | Si | F* | 60 min | 16.2 mg | |
| Embodiment 8 | Si | F* | 100 min | 22.5 mg | |
| Comparison example 2 | Si | F₂ | 100 min | <0.1 mg | |
| Comparison example 3 | Si | NF₃ | 100 min | <0.1 mg | |
| Comparison example 4 | Si | CF₄ | 100 min | <0.1 mg | |
| Comparison example 5 | Si | CF₄ 95%+ O₂ 5% | 100 min | <0.1 mg | |
| Comparison example 6 | Si | C₂F₆ 95%+ O₂ 5% | 100 min | <0.1 mg | |

### Embodiments 9 to 11:

### Etching and cleaning of silicon oxide, silicon nitride and silicon carbide.

Layers of silicon oxide, silicon nitride and silicon carbide, with a thickness of 10,000 A, were formed respectively on SUS 316L plates of 100 x 100 x imm thickness for use as the test pieces.

The test piece was installed inside the plasma CVD unit and reacted by introducing undiluted active fluorine at a pressure of 5 Torr at a flow rate of 30 SCCM at a temperature of 100°C with the high frequency power source switched off.

Table 2 shows the result of the investigations in terms of the reduction in mass of silicon oxide, silicon nitride and silicon carbide observed for a gas passing time of 3 minutes.

### Comparison Examples 7 to 15

### Etching and cleaning of silicon oxide, silicon nitride and silicon carbide

Table 2 shows the result of reacting fluorine, nitrogen trifluoride, a mixed gas of 95% carbon tetrafluoride and 5% oxygen, and a mixed gas of 5% dicarbon hexafluoride and 5% oxygen under the same conditions and for a gas passing time of 100 minutes as using the same test pieces as those of Embodiments 9 to 11.

**Table 2**

| | Circuit Board | Gas Name | Gas Passing Time | Reduction mass | Remarks |
|---|---|---|---|---|---|
| Embodiment 9 | Silicon oxide | F* | 3 min | 14.2 mg | The circuit board was partially exposed. |
| Comparison example 7 | Silicon oxide | F₂ | 100 min | 0.3 mg | |
| Comparison example 8 | Silicon oxide | NF₃ | 100 min | <0.1 mg | |
| Comparison example 9 | Silicon oxide | CF₄ 95%+ O₂ 5% | 100 min | <0.1 mg | |
| Embodiment 10 | Silicon nitride | F* | 3 min | 33.7 mg | The circuit board was almost entirely exposed. |
| Comparison example 10 | Silicon nitride | F₂ | 100 min | 1.4 mg | |
| Comparison example 11 | Silicon nitride | NF₃ | 100 min | <0.1 mg | |
| Comparison example 12 | Silicon nitride | CF₄ 95%+ O₂ 5% | 100 min | <0.1 mg | |
| Embodiment 11 | Silicon carbide | F* | 3 min | 6.6 mg | |
| Comparison example 13 | Silicon carbide | F₂ | 100 min | 0.1 mg | |
| Comparison example 14 | Silicon carbide | NF₃ | 100 min | <0.1 mg | |
| Comparison example 15 | Silicon carbide | CF₄ 95% O₂ 5% | 100 min | <0.1 mg | |

## Claims

1. A system for producing active fluorine comprising :-
i) a transportable vessel containing a solid alkali metal fluorohalate, preferably tetrafluorohalate,
ii) means for heating the solid alkali metal fluorohalate, and
iii) an outlet from the vessel from which the active fluorine gas produced on heating exits the vessel.

2. A system according to claim 1 in which the alkali metal fluorohalate is MXF₍ₙ₊₁₎, where M is K, Rb or Cs, X is Cl, Br, I and n is 1, 3, 5 or 7.

3. A system according to claim 1 or claim 2 in which the fluorohalate is KClF₄ or RbClF₄ or CsClF₄.

4. A system according to any of claims 1 to 3 in which the transportable vessel is a cylinder which is adapted to be able to contain the solid alkali metal tetrafluorohalate.

5. A system according to any of claims 1 to 4 in which the heater is an integral part of the vessel.

6. A system according to any of claims 1 to 5 in which the device is recharged following use.

7. A method of providing a source of active fluorine comprising:-
i) generating a solid alkali metal fluorohalates, preferably tetrafluorohalate,
ii) transporting and storing the source as a solid alkali metal fluorohalate, and
iii) heating the fluorohalate at the point of use to generate active fluorine gas.

8. The method of claim 7 in which the active fluorine comprises fluorine alone or in combination with any halogen but fluorine, for instance the fluorine may be or may include F, F₂, ClF₃, ClF₅, IF₅, BrF₃ or mixtures thereof.

9. A method according to claim 7 or claim 8 in which the the MClF₄, (where M equals alkali metal) contained within the vessel is heated to a temperature at which the MClF₄, decomposes to form active fluorine gas.

10. A method according to claim 9 in which the solid alkali metal tetrafluorchlorate is heated to a temperature of at least 130°C, or at least 180°C.

11. A method according to any of claims 7 to 10 in which the decomposition is carried out in a vacuum or in an inert gas stream or in the presence of active fluorine.

12. The use of alkali metal fluorohalate, preferably tetrafluorohalate, as a transportable and/or storable source of active fluorine.

13. A method of cleaning and/or etching comprising producing active fluorine by a device according to any of claims 1 to 6 and/or according to che method of any of claims 7 to 11 and applying the active fluorine to a material to be cleaned or etched.

14. A method according to claim 13 in which the active fluorine is used for cleaning chemical vapour deposition equipment and/or for removal of silicon and/or germanium and/or copper and/or compounds thereof, from semi-conductor manufacturing apparatus, liquid crystal manufacturing apparatus or associated accessories thereof, and/or for cleaning piping.

15. A method according to claim 13 or claim 14 in which the active fluorine is used for etching silicon, germanium, copper or compounds thereof.

16. A method of passivating metals by fluorination using active fluorine generated using the device of any of claims 1 to 6 and/or using the method of any of claims 7 to 11.

## Patentansprüche

1. System zum Herstellen von aktivem Fluor, umfassend:
i) ein transportierbares Gefäß, das ein festes Alkalimetallfluorhalat, vorzugsweise - tetrafluorhalat, enthält,
ii) Mittel zum Erhitzen des festen Alkalimetallfluorhalats und
iii) Auslaß aus dem Gefäß, aus welchem das aktive Fluorgas, das bei Erwärmen entsteht, aus dem Gefäß ausströmt.

2. System nach Anspruch 1, in welchem das Alkalimetallfluorhalat MXF₍ₙ₊₁₎ ist, wobei M K, Rb oder Cs ist, X C1, Br, I ist und n 1, 3, 5 oder 7 ist.

3. System nach Anspruch 1 oder 2, in welchem das Fluorhalat KClF₄, RbClF₄ oder CsClF₄ ist.

4. System nach irgendeinem der Ansprüche 1 bis 3, in welchem das transportierbare Gefäß ein Zylinder ist, der geeignet ist, das feste Alkalimetalltetrafluorhalat zu enthalten.

5. System nach irgendeinem der Ansprüche 1 bis 4, in welchem das Heizelement ein integraler Bestandteil des Gefäßes ist.

6. System nach irgendeinem der Ansprüche 1 bis 5, in welchem das Gerät nach der Verwendung nachgeladen wird.

7. Verfahren zum Bereitstellen einer Quelle von aktivem Fluor, umfassend:
i) Erzeugen eines festen Alkalimetallfluorhalats, vorzugsweise -tetrafluorhalats,
ii) Transportieren und Speichern der Quelle als ein festes Alkalimetallfluorhalat und
iii) Erwärmen des Fluorhalats am Verwendungsort, um aktives Fluorgas zu erzeugen.

8. Verfahren nach Anspruch 7, in welchem das aktive Fluor Fluor allein oder in Kombination mit irgendeinem Halogen außer Fluor umfaßt, das Fluor zum Beispiel F, F₂, ClF₂, ClF₅, IF₅, BrF₃ oder Mischungen davon sein oder umfassen kann.

9. Verfahren nach Anspruch 7 oder 8, in welchem das MClF₄ (wobei M gleich Alkalimetall ist), das im Gefäß enthalten ist, bis zu einer Temperatur erwärmt wird, bei welcher sich das MClF₄ zersetzt, um aktives Fluorgas zu bilden.

10. Verfahren nach Anspruch 9, in welchem das feste Alkalimetalltetrafluorhalat bis zu einer Temperatur von wenigstens 130 °C oder wenigstens 180 °C erwärmt wird.

11. Verfahren nach irgendeinem der Ansprüche 7 bis 10, in welchem die Zersetzung in einem Vakuum oder in einem Inertgasstrom oder in der Gegenwart von aktivem Fluor ausgeführt wird.

12. Verwendung von Alkalimetallfluorhalat, vorzugsweise -tetrafluorhalat, als eine transportable und/oder speicherbare Quelle von aktivem Fluor.

13. Verfahren zum Reinigen und/oder Ätzen, umfassend das Herstellen von aktivem Fluor durch ein Gerät nach einem der Ansprüche 1 bis 6 und/oder nach dem Verfahren nach einem der Ansprüche 7 bis 11 und Anwenden des aktiven Fluors auf ein zu reinigendes oder zu ätzendes Material.

14. Verfahren nach Anspruch 13, in welchem das aktive Fluor verwendet wird zum Reinigen von Ausrüstung zur chemischen Abscheidung aus der Gasphase und/oder zum Entfernen von Silizium und/oder Germanium und/oder Kupfer und/oder Verbindungen davon von Halbleiter-Produktionsvorrichtungen, Flüssigkristall-Produktionsvorrichtungen oder verbundenem Zubehör davon und/oder zum Reinigen von Rohrleitungen.

15. Verfahren nach Anspruch 13 oder 14, in welchem das aktive Fluor zum Ätzen von Silizium, Germanium, Kupfer oder Verbindungen davon verwendet wird.

16. Verfahren zum Passivieren von Metallen durch Fluorination unter Verwendung von aktivem Fluor, das erzeugt wird durch Verwenden des Geräts nach einem der Ansprüche 1 bis 6 und/oder Verwenden des Verfahrens nach einem der Ansprüche 7 bis 11.

## Revendications

1. Système de production de fluor actif comprenant :
i) un récipient mobile contenant un fluorohalate de métal alcalin solide, de préférence un tétrafluorohalate,
ii) des moyens pour chauffer le fluorohalate de métal alcalin solide, et
iii) une sortie du récipient de laquelle le fluor gazeux actif produit par chauffage sort du récipient.

2. Système selon la revendication 1, dans lequel le fluorohalate de métal alcalin est MXF₍ₙ₊₁₎, où M est K, Rb ou Cs, X est Cl, Br ou I, et n vaut 1, 3, 5 ou 7.

3. Système selon la revendication 1 ou la revendication 2, dans lequel le fluorohalate est KClF₄, RbClF₄ ou CsClF₄.

4. Système selon l'une quelconque des revendications 1 à 3, dans lequel le récipient mobile est un cylindre qui est conçu pour pouvoir contenir le tétrafluorohalate de métal alcalin solide.

5. Système selon l'une quelconque des revendications 1 à 4, dans lequel le dispositif de chauffage fait partie intégrante du récipient.

6. Système selon l'une quelconque des revendications 1 à 5, dans lequel le dispositif est rechargé après emploi.

7. Procédé pour fournir une source de fluor actif comprenant :
i) la production d'un fluorohalate de métal alcalin solide, de préférence un tétrafluorohalate,
ii) le transport et le stockage de la source sous forme d'un fluorohalate de métal alcalin solide, et
iii) le chauffage du fluorohalate au point d'utilisation pour produire du fluor gazeux actif.

8. Procédé selon la revendication- 7, dans lequel le fluor actif comprend du fluor seul ou en combinaison avec tout atome d'halogène hormis le fluor, par exemple le fluor peut être ou peut comprendre F, F₂, ClF₃, ClF₅, IF₅, BrF₃ ou des mélanges de ceux-ci.

9. Procédé selon la revendication 7 ou la revendication 8, dans lequel le MClF₄ (où M représente un métal alcalin) contenu dans le récipient est chauffé à une température à laquelle le MClF₄ se décompose pour former du fluor gazeux actif.

10. Procédé selon la revendication 9, dans lequel le tétrafluorohalate de métal alcalin solide est chauffé à une température d'au moins 130°C, ou d'au moins 180°C.

11. Procédé selon l'une quelconque des revendications 7 à 10, dans lequel la décomposition est réalisée sous vide ou sous un courant de gaz inerte ou en présence de fluor actif.

12. Utilisation d'un fluorohalate de métal alcalin, de préférence un tétrafluorohalate, comme une source mobile et/ou pouvant être stockée de fluor actif.

13. Procédé de nettoyage et/ou de décapage comprenant la production de fluor actif par un dispositif selon l'une quelconque des revendications 1 à 6 et/ou par le procédé selon l'une quelconque des revendications 7 à 11 et l'application du fluor actif sur un matériau à nettoyer ou à décaper.

14. Procédé selon la revendication 13, dans lequel le fluor actif est utilisé pour nettoyer un équipement de dépôt chimique en phase vapeur et/ou pour éliminer du silicium et/ou du germanium et/ou du cuivre et/ou des composée de ceux-ci, d'un appareil de fabrication de semi-conducteurs, d'un appareil de fabrication de cristaux liquides ou d'accessoires associés de ceux-ci, et/ou pour nettoyer des tuyaux.

15. Procédé selon la revendication 13 ou la revendication 14, dans - lequel le fluor actif est utilisé pour décaper du silicium, du germanium, du cuivre ou des composés de ceux-ci.

16. Procédé de passivation de métaux par fluoration à l'aide de fluor actif produit par le dispositif selon l'une quelconque des revendications 1 à 6 et/ou par le procédé selon l'une quelconque des revendications 7 à 11.
